(19) Europäisches Patentamt
European Patent Office
Office européen des brevets

(11) **EP 1 614 138 B1**

(12) **EUROPÄISCHE PATENTSCHRIFT**

(45) Veröffentlichungstag und Bekanntmachung des Hinweises auf die Patenterteilung:
**31.03.2010   Patentblatt 2010/13**

(21) Anmeldenummer: **04726483.3**

(22) Anmeldetag: **08.04.2004**

(51) Int Cl.:
***H01J 37/32*** *(2006.01)*

(86) Internationale Anmeldenummer:
**PCT/EP2004/003796**

(87) Internationale Veröffentlichungsnummer:
**WO 2004/091264 (21.10.2004 Gazette 2004/43)**

(54) **HOCHFREQUENZ-PLASMASTRAHLQUELLE UND VERFAHREN ZUM BESTRAHLEN EINER OBERFLÄCHE**

HIGH FREQUENCY PLASMA JET SOURCE AND METHOD FOR IRRADIATING A SURFACE

SOURCE DE FAISCEAU PLASMA HAUTE FREQUENCE ET PROCEDE D'EXPOSITION D'UNE SURFACE A UN RAYONNEMENT

(84) Benannte Vertragsstaaten:
**AT BE BG CH CY CZ DE DK EE ES FI FR GB GR HU IE IT LI LU MC NL PL PT RO SE SI SK TR**

(30) Priorität: **11.04.2003   DE 10317027**

(43) Veröffentlichungstag der Anmeldung:
**11.01.2006   Patentblatt 2006/02**

(73) Patentinhaber: **Leybold Optics GmbH**
**63755 Alzenau (DE)**

(72) Erfinder: **BECKMANN, Rudolf**
**63546 Hammersbach (DE)**

(74) Vertreter: **Pohlmann, Bernd Michael**
**Reinhardt & Pohlmann**
**Patentanwälte**
**Rossmarkt 12**
**60311 Frankfurt am Main (DE)**

(56) Entgegenhaltungen:
**EP-B- 0 349 556      US-A- 4 401 054**
**US-A- 5 036 252**

• **PATENT ABSTRACTS OF JAPAN Bd. 2000, Nr. 25, 12. April 2001 (2001-04-12) -& JP 2001 210245 A (SHINCRON:KK), 3. August 2001 (2001-08-03)**
• **PATENT ABSTRACTS OF JAPAN Bd. 0142, Nr. 39 (E-0930), 21. Mai 1990 (1990-05-21) & JP 2 065230 A (MITSUBISHI ELECTRIC CORP), 5. März 1990 (1990-03-05)**

EP 1 614 138 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf eine Hochfrequenz-Plasmastrahlquelle sowie ein Verfahren zum Bestrahlen einer Oberfläche mit einem Plasmastrahl gemäß den Oberbegriffen der unabhängigen Patentansprüche.

Bei Vakuumbeschichtungsverfahren von Substraten werden häufig so genannte Hochfrequenz-Plasmastrahlquellen eingesetzt. Ein Plasma enthält neben neutralen Atomen und/oder Molekülen Elektronen und positive Ionen als geladene Teilchen. Die geladenen Teilchen werden durch elektrische und/oder magnetische Felder gezielt beschleunigt und z. B. zum Abtragen einer Oberfläche oder zum Eintragen reaktiver Komponenten wie z. B. Sauerstoff in eine frisch aufwachsende Beschichtung eingesetzt und dergleichen mehr. Bekannt sind auch ionengestützte Verfahren, bei denen Material aus einer Materialquelle, typischerweise einer Verdampferquelle, verdampft wird und sich auf einem Substrat niederschlägt. Das auf dem Substrat aufwachsende Material wird mit einer reaktiven Komponente aus einem Plasma, beispielsweise Sauerstoff, beaufschlagt und bildet so z.B. eine Oxidschicht. Solche Verfahren sind z. B. bei der Herstellung transparenter Schichten für optische Anwendungen üblich. Dabei ist es auch von erheblicher Bedeutung, wie gleichmäßig der Plasmastrahl die Schicht beaufschlagt da die optischen Eigenschaften solcher Schichten in der Regel stark mit dem Sauerstoffgehalt variieren.

Bei der Herstellung dünner Schichten in der Mikroelektronik oder für optische Anwendungen wird in der Regel die Bereitstellung möglichst gleichmäßiger Schichtdicken und Schichteigenschaften, wie z. B der Brechwert der abgeschiedenen Schichten angestrebt. Im industriellen Einsatz werden dabei große Flächen und/oder viele Substrate gleichzeitig beschichtet, was die Problematik der Schichtdickenhomogenität erhöht. Besonders bei optischen Schichten werden Schichtdickenschwankungen über eine Fläche oder die Substrate einer Beschichtungscharge von allenfalls wenigen Prozent als tolerabel betrachtet.

Aus dem europäischen Patent EP 349 556 B1 ist eine Hochfrequenz-Plasmastrahlquelle zur Sicherstellung eines möglichst großflächigen homogenen Beschusses von Oberflächen mit Atom- oder Molekülstrahlen einer hohen Parallelität bekannt. Die Öffnung der Hochfrequenz-Plasmastrahlquelle ist dabei mit einem Extraktionsgitter versehen, welches eine geringe Maschenweite aufweist, um das Plasma nicht zu stören. Das Extraktionsgitter ist als Hochfrequenz führende Elektrode in Form eines geeignet konfigurierten Drahtnetzes oder in Form parallel verlaufender Drähte ausgeführt. Zwischen dem Plasma und dem Extraktionsgitter wird eine ionenbeschleunigende Potentialdifferenz erzeugt, die einen neutralen Plasmastrahl ermöglicht, der quer zur Strahlrichtung völlig homogen ist und keinerlei Modulationsstruktur aufweist. Um stets eine gute Ebenheit der Fläche des Extraktionsgitters aufrechtzuerhalten und eine nachteilige Beeinflussung des Plasmastrahls durch eine Verformung des Extraktionsgitters zu vermeiden, wird die Gitterhalterung des Extraktionsgitters der bekannten Hochfrequenz-Plasmastrahlquelle mit einer Nachspannvorrichtung versehen. Es ist üblich, den Durchmesser der Hochfrequenz-Plasmastrahlquelle zu vergrößern, um eine großflächigere Bestrahlung zu ermöglichen. Dies erhöht jedoch die Kosten und stößt zudem schnell an konstruktive Grenzen.

Bei Aufdampfprozessen wird eine Großzahl von Substraten gleichmäßig beschichtet, indem die Substrate auf einer Kalotte angeordnet sind. Hierbei wird eine besonders große Fläche gleichmäßig beschichtet.

Wenn die bekannte Hochfrequenz-Plasmastrahlquelle zur großflächigen Abscheidung von Schichten auf Substraten verwendet wird, die auf einer solchen Kalotte oder anderen gekrümmten Flächen angeordnet sind, zeigt sich ferner, dass auch bei einer Vergrößerung des Durchmessers der Hochfrequenz-Plasmastrahlquelle Einbußen bei der Homogenität der abgeschiedenen Schichtdicke und Schichteigenschaften hingenommen werden müssen. Dies hat zur Folge, dass eine großflächige Bestrahlung nicht mit der gewünschten Qualitätsanforderung erfolgen kann.

Aus der US 6250070 B1 ist eine Hochfrequenz - Ionenstrahlquelle mit zwei Gittern zum Extrahieren und Beschleunigen von Ionen bekannt. Die Gitter sind vom Plasmaraum ausgesehen konkav ausgebildet um zwischen ihnen einen Abstand mit hoher Genauigkeit unabhängig von Temperaturänderungen genau einhalten zu können.

Aufgabe der vorliegenden Erfindung ist die Schaffung einer Hochfrequenz-Plasmastrahlquelle, einer Vakuumkammer mit einer derartigen Hochfrequenz-Plasmastrahlquelle sowie eines Verfahren zum Bestrahlen einer Oberfläche mit einem Plasmastrahl, die eine großflächige und hochqualitative Bestrahlung von Oberflächen ermöglichen.

Diese Aufgabe wird erfindungsgemäß mit den Merkmalen der unabhängigen Ansprüche gelöst.

Gemäß einem bevorzugten Aspekt der Erfindung wird entgegen der Lehre des Standes der Technik ein divergenter neutraler Plasmastrahl erzeugt.

Ein Vorteil der Erfindung ist, dass es durch die erfindungsgemäße Ausbildung der Hochfrequenz-Plasmastrahlquelle gelingt, auch auf Substraten, die auf einer Kalotte angeordnet sind, homogen großflächig Schichten abzuscheiden oder größere Flächen zu reinigen.

Nachfolgend wird die Erfindung anhand von Zeichnungen näher beschrieben, aus denen sich auch unabhängig von der Zusammenfassung in den Patentansprüchen weitere Merkmale, Einzelheiten und Vorteile der Erfindung ergeben.

Es zeigen in schematischer Darstellung:

Figur 1      eine Beschichtungskammer mit einer bevorzugten Hochfrequenz- Plasmastrahlquelle,

Figur 2     Verteilungskurven einer cosn-Strahlcharakteristik,

Figur 3     die geometrischen Verhältnisse in der Beschichtungskammer aus Fig. 1, wobei Substrate auf einer Kalotte angeordnet sind,

Figur 4     Verteilungen eines Brechwertes von TiO$_2$-Schichten auf einer Kalotte,

Figur 5     den Einfluss der Größe der Austrittsöffnung einer Hochfrequenz- Plasmastrahlquelle und der Strahldivergenz auf die Verteilung der Plasmastrahldichte auf einer Kalotte,

Figur 6     eine Hochfrequenz-Plasmastrahlquelle nach dem Stand der Technik,

Figur 7     die Dicke der Raumladungszone in Abhängigkeit von der angelegten Extraktionsspannung,

Figur 8     die Dicke der Raumladungszone in Abhängigkeit von der Stromdichte bei einer festen Extraktionsspannung,

Figur 9     eine bevorzugte Ausgestaltung des Extraktionsgitters und

Figur 10    eine weitere bevorzugte Ausgestaltung des Extraktionsgitters.

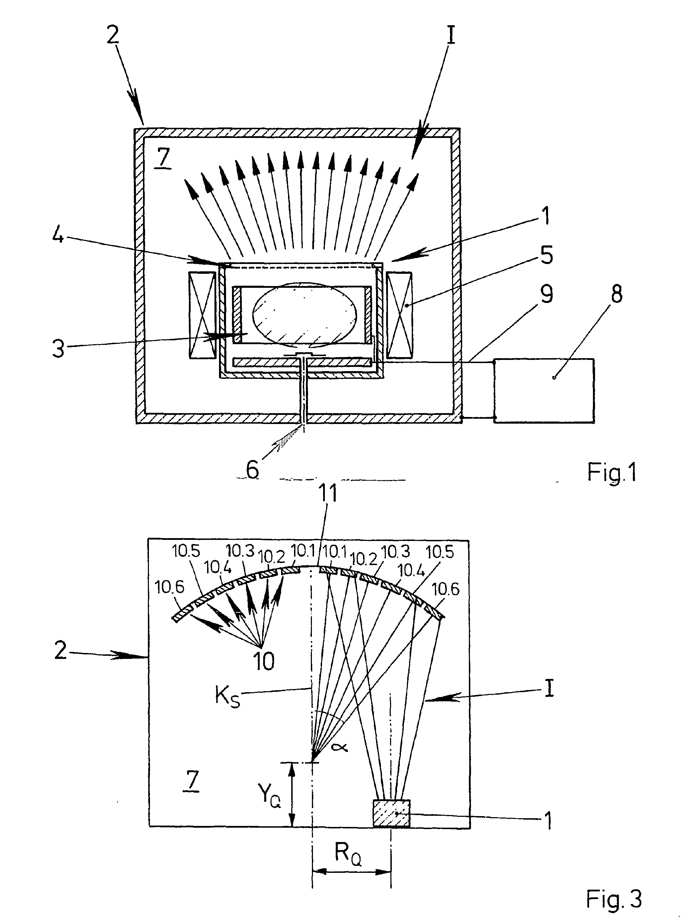

Figur 1 zeigt schematisch eine Hochfrequenz-Plasmastrahlquelle 1, im folgenden Hf-Plasmastrahlquelle genannt, mit einem divergenten neutralen Plasmastrahl I. Die Hf-Plasmastrahlquelle 1 ist topfartig ausgebildet und in einem Bereich einer als Beschichtungskammer 7 ausgebildeten Vakuumkammer angeordnet, die von einem Gehäuse 2 umgeben ist. Details der Beschichtungskammer 7 wie etwa übliche Vakuumpumpen, Gasversorgung, Substrathalterungen, Analytik etc. sind nicht dargestellt. Die Hf-Plasmastrahlquelle 1 weist einen Plasmaraum 3 auf, in dem ein Plasma gezündet wird, z. B. durch eine Hochfrequenzeinstrahlung. Zum Zünden und Aufrechterhalten des Plasmas sind elektrische Mittel 8, 9 vorgesehen, etwa ein Hochfrequenz-Sender 8 und elektrische Verbindungen 9. Weiterhin kann zumindest ein Magnet 5 vorgesehen sein, der in üblicher Weise zum Einschließen des Plasmas in dem Plasmaraum 3 eingesetzt wird. Für eine Gasversorgung der Hf-Plasmastrahlquelle 1 ist eine Zuführung 6 vorgesehen. Zum Extrahieren eines neutralen Plasmastrahls aus dem Plasma im Plasmaraum 3 ist in einem Bereich einer Austrittsöffnung ein Extraktionsgitter 4 mit vorzugsweise hoher Transmission angeordnet. Der zur Transmission zur Verfügung stehende, insbesondere nicht abgedeckte Bereich der Fläche des Extraktiergitters 4, wird als Quellengröße bezeichnet. Im Allgemeinen wird die Quellengröße durch die Größe der Austrittsöffnung festgelegt. Eine derartige Quelle ist, allerdings mit einem planaren Extraktionsgitter und mit einem stark gerichteten Plasmastrahl, bereits aus der EP 349 556 B1 bekannt. Bevorzugt ist eine nach dem ECWR - Prinzip arbeitende Quelle mit einem Plasma relativ hoher Dichte.

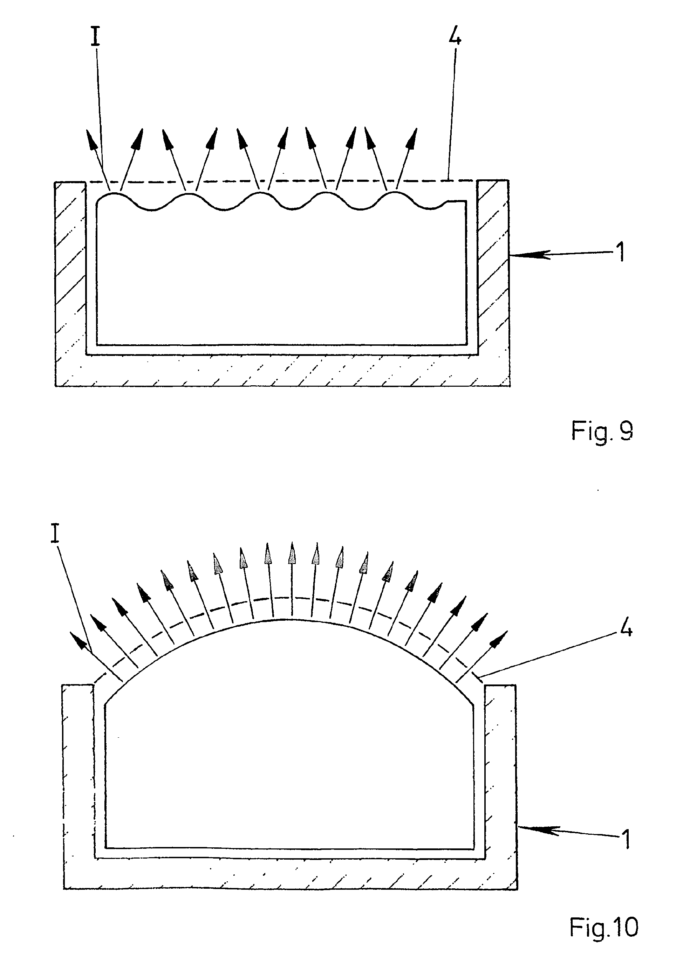

Ein erfindungsgemäß divergenter Plasmastrahl I wird bevorzugt durch eine gezielte Wechselwirkung zwischen dem Plasma und dem Extraktionsgitter 4 bewirkt. Das Extraktionsgitter 4 ist dergestalt ausgebildet, dass der Plasmastrahl I eine im wesentlichen divergente Strahlcharakteristik aufweist. Details entsprechender Extraktionsgitter 4 sind in den Figuren 9 und 10 näher gezeigt.

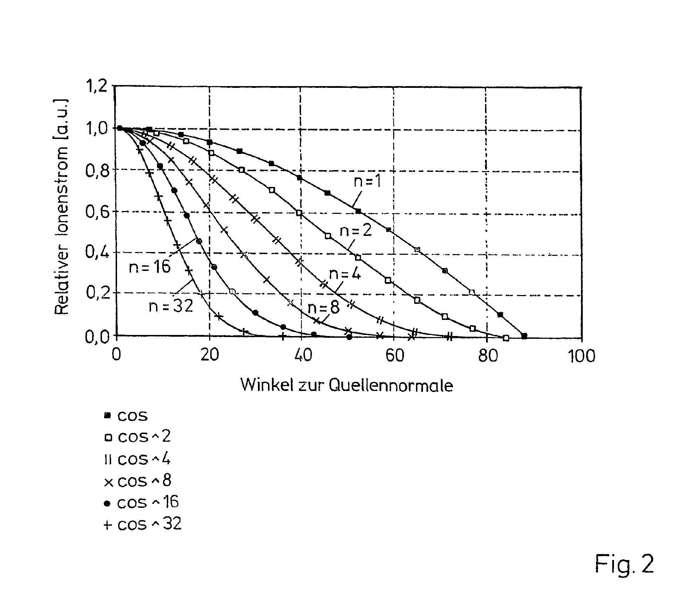

Unter einem divergenten Plasmastrahl soll ein Plasmastrahl verstanden werden, der auch in zumindest einer Richtung senkrecht zur Hauptstrahlrichtung, d.h. der Richtung mit der höchsten Plasmastrahldichte, noch merklich abstrahlt. Üblicherweise wird die Hauptstrahlrichtung als Quellennormale bezeichnet. Eine Strahldivergenz lässt sich näherungsweise durch einen Exponenten n einer Cosinus-Verteilung beschreiben. Der Exponent n der Cosinus-Verteilung ist ein Maß für die Strahldivergenz. Je größer n, desto gerichteter ist der Plasmastrahl; je kleiner n ist, desto divergenter ist der Plasmastrahl. Eine detailliertere Abhandlung über derartige Verteilungsfunktionen ist bei G. Deppisch: "Schichtdickengleichmäßigkeit von aufgedampften Schichten in Theorie und Praxis", Vakuum Technik, 30. Jahrgang, Heft 3, 1981 zu finden. Fig. 2 zeigt Kurven von cos$^n$-Verteilungen eines relativen Ionenstroms eines Plasmastrahls als Funktion des Winkels der Abstrahlung zur Quellennormalen für verschiedene Werte n. Es handelt sich bei dieser Verteilung um eine mathematisch berechnete Größe, die angibt, wie stark die Ionenstrahldichte vom Winkel abhängt. Es wird bei einem stark divergenten Strahl (n=1) unter einem Winkel von z. B. 40 zur Quellennormalen noch 78% des Wertes erreicht, der in Richtung der Quellennormalen emittiert wird. Bei n=8 wird unter diesem Winkel dagegen nur noch 13% emittiert. Bei einem Plasmastrahl mit n= 16 oder n=36 ist bei einem Winkel von 40° praktisch kein Plasmastrahl vorhanden.

In Fig. 3 sind die geometrischen Verhältnisse in einer als Beschichtungskammer ausgebildeten Vakuumkammer 7 dargestellt. In der Beschichtungskammer 7 sind eine Mehrzahl von Substraten 10.1, 10.2, 10.3, 10.4, 10.5, 10.6 auf einer im wesentlichen kugelförmigen Kalotte 11 angeordnet. Die Kalotte 11 ist in Form eines Ausschnitts einer Kugelschale ausgebildet. Die Substrate 10.1, 10.2, 10.3, 10.4, 10.5, 10.6 sind jeweils auf Kreisen auf der Kalotte 11 abgelegt, d.h. jedes Bezugszeichen kennzeichnet eine Mehrzahl von Substraten, die auf dem jeweiligen Kreis auf der Kalotte 11 angeordnet sind. Die senkrecht gestrichelten Linien entsprechen der Richtung einer Quellennormalen, bzw. einer Parallelen dazu. Der innerste Kreis mit den Substraten 10.1 entspricht einem Kalottenwinkel $\alpha$ von z. B. 9°, der nächste Kreis mit den Substraten 10.2 einem Winkel von $\alpha = 14°$, der nächste Kreis mit den Substraten 10.3 einem Winkel von $\alpha = 21°$, der nächste Kreis mit den Substraten 10.4 einem Winkel von $\alpha = 27°$, der nächste einem Winkel von $\alpha = 33°$, und der äußerste Kreis einem Winkel von $\alpha = 39°$. Die Kalotte 11 kann während der Beschichtung rotieren, um eine bessere Schichtdickenhomogenität zu erlangen. Die Hf-Plasmastrahlquelle 1 ist im vorliegenden Fall versetzt zum Symmetriezentrum der Kalotte 11 angebracht, wobei $R_Q$ den radialen Abstand der Quelle zur Symmetrie-Achse $K_S$ der Kalotte 11 bezeichnet. Neben $R_Q$ können insbesondere die Richtung der Quellennormalen und/oder der Abstand $Y_Q$ variiert werden, um gezielt die Intensität des Plasmastrahls I auf den Substraten 10.1, 10.2, 10.3, 10.4, 10.5, 10.6 zu beeinflussen. Bevorzugt kann auch eine weitere Materialquelle in der Beschichtungskammer 7 vorgesehen sein, insbesondere eine Verdampfungsquelle. Zudem kann die Quelle unter einem Winkel Beta gegen die Richtung der Symmetrieachse gekippt werden. Bei anderen Ausbildungen der Erfindung kann die Oberfläche, auf der die Substrate angeordnet sind eine andere, vorzugsweise gekrümmte Form aufweisen.

Üblicherweise würde, um eine möglichst gleichmäßige großflächige Ausleuchtung der Kalotte 11 zu erreichen, eine Hf-Plasmastrahlquelle 1 mit einer möglichst großen Austrittsöffnung und einem gerichteten Plasmastrahl gewählt. Allerdings zeigen die praktischen Ergebnisse von Beschichtungsversuchen sowie Simulationsrechnungen, für eine derartige Anlagenkonfiguration, dass durch eine Vergrößerung der Austrittsöffnung nur bedingt eine ausreichende Homogenität der Schichtdicke der auf den Substraten abgeschiedenen Beschichtungen erzielt wird. Eine Verbesserung der Beschichtungsqualität insbesondere der Schichtdickenhomogenität ist erfindungsgemäß jedoch durch Verwendung eines divergenten Plasmastrahls I möglich.

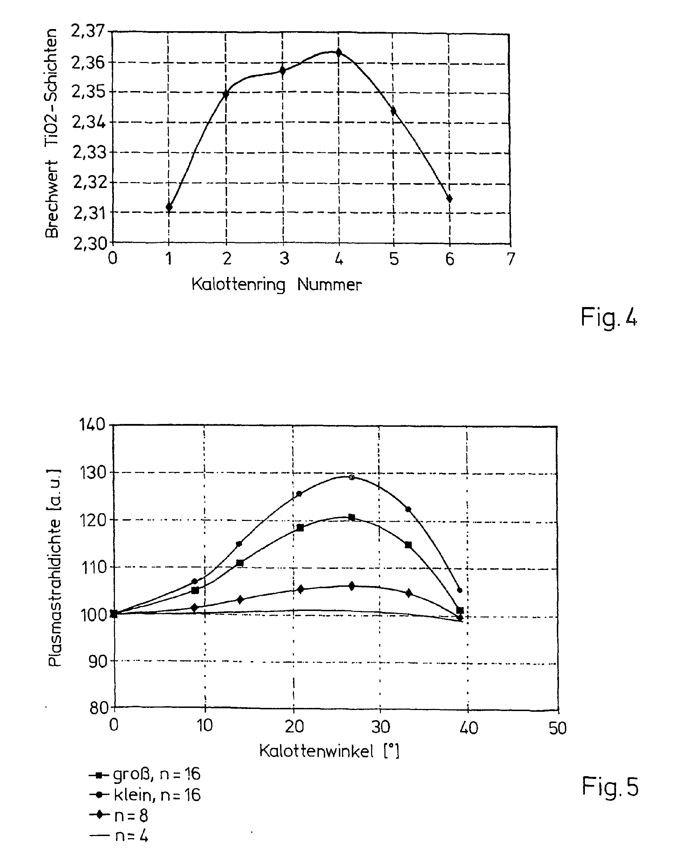

Fig. 4 zeigt Brechwertverteilungen von $TiO_2$-Schichten auf einer im wesentlichen kugelförmigen Kalotte. Dabei wurde mit einer Hf-Plasmastrahlquelle mit $16 \leq n \leq 32$ und großer Austrittsöffnung in einer Beschichtungskammer 7 wie in Fig. 1 und Fig. 2 dargestellt, Titandioxid $TiO_2$ abgeschieden. $TiO_2$ ist transparent und weist einen Brechwert auf, der von der Intensität des verwendeten Plasmastrahls abhängt. Die Austrittsöffnung der Hf-Plasmastrahlquelle weist eine Fläche von $18.750 mm^2$ auf. Bei einer homogenen Bestrahlung der Kalotte 11 müsste der optische Brechwert homogen über der Kalotte 11 sein. Ohne Plasmabestrahlung liegt der Brechwert bei etwa 2,2 und erreicht bei sehr hohen Strahldichten des Plasmastrahls einen Wert bis zu 2,4. Die Messergebnisse in Fig. 4 zeigen, dass aufgrund der Variation der Plasmastrahldichte der Brechwert bei einer Beschichtung auf den Positionen 1 und 6 um etwa 30% geringer ist als auf den Positionen 2 bis 5, wobei die Positionen den erwähnten Kreisen 10.1,..... auf der Kalotte 11 in Fig. 2 und den zugeordneten Winkeln auf der Kalotte 11 entsprechen.

Fig. 5 zeigt Ergebnisse einer Simulationsrechnung über den Einfluss der Größe der Austrittsöffnung einer Hf-Plasmastrahlquelle sowie der Strahldivergenz auf die Verteilung der Plasmastrahldichte auf einer Kalotte. Bei einer Hf-Plasmastrahlquelle mit n=16 und einer relativ kleinen Austrittsöffnung (nur 1/10 der Fläche wie in Fig. 4) ist die Plasmastrahldichte am stärksten vom Kalottenwinkel abhängig (oberste Kurve). Bei einer Hf-Plasmastrahlquelle mit gleicher Divergenz von n=16, aber einer größeren Austrittsöffnung, ist die Winkelabhängigkeit etwas geringer. Die Kurven mit n=8 und n=4 sind ebenso mit der kleinen Austrittsöffnung gerechnet. Es ist deutlich erkennbar, dass mit zunehmender Divergenz, d.h. abnehmendem Exponenten n, die Plasmastrahldichte weniger mit dem Kalottenwinkel variiert. Damit nimmt die Homogenität des Plasmastrahls über der Kalotte zu.

Ein divergenter Plasmastrahl I ermöglicht auf einfache Weise eine homogene großflächige Bestrahlung der Kalotte 11. Bei einer Abscheidung von Material auf einem Substrat und/oder einer Bestrahlung des Substrats mit einem Plasmastrahl, z. B. zur Modifizierung des Substrates führt ein divergenter Plasmastrahl zu wesentlich homogeneren Ergebnissen als eine konventionelle Lösung mit einer Hf-Plasmastrahlquelle mit größerer Austrittsöffnung und einem Plasmastrahl hoher Parallelität. Bei einer planaren Oberfläche ist bei einem divergenten Plasmastrahl eine geringere Homogenität der Bestrahlung zu erwarten, die jedoch für viele Anwendungen, wie beispielsweise die Reinigung von Oberflächen noch ausreichend ist.

Bei dem erfindungsgemäßen Verfahren zur Bestrahlung einer Oberfläche wird ein Plasmastrahl I einer Hochfrequenz-Plasmastrahlquelle mit einer hohen Strahldivergenz, vorzugsweise mit einem Divergenzmaß von höchstens n=16, besonders n= 4 und n= 10, verwendet, wobei n ein Exponent der Cosinus-Verteilungsfunktion $cos^n$ ist, welcher die Strahldivergenz beschreibt. Ein Plasmastrahl I mit dieser Strahlcharakteristik ermöglicht beispielsweise eine Plasmastrahldichte hoher Homogenität auf den Substraten 10.1,...auf der Kalotte 11 und modifiziert eine Beschichtung und/oder führt Komponenten, beispielsweise Sauerstoff, zu.

Es versteht sich, dass die Erfindung nicht auf Hf- Plasmastrahlquellen beschränkt ist, deren divergente Strahlcharakteristik durch eine Cosinus-Verteilungsfunktion charakterisiert werden kann, sondern jede geeignete gezielte divergente Strahlcharakteristik umfasst.

Eine gewünschte divergente Strahldivergenz lässt sich zweckmäßigerweise gezielt durch konstruktive Ausgestaltung der Hf-Plasmastrahlquelle 1 erreichen. Dabei wird vorzugsweise das Extraktionsgitter 4 im Bereich der Austrittsöffnung der Hf-Plasmastrahlquelle 1 gegenüber den aus dem Stand der Technik bekannten Ausbildungsformen modifiziert. Es werden drei Möglichkeiten bevorzugt. Das Extraktionsgitter 4 weist Maschen mit einer großen Maschenweite auf oder es ist nicht planar, sondern zum Plasma hin konkav oder konvex ausgebildet. Ferner kann das Extraktionsgitter 4 eine konkave oder konvexe Form sowie Maschen mit großer Maschenweite aufweisen. Das Extraktionsgitter 4 besteht bevorzugt aus einem Wolframnetz mit einer Drahtstärke von etwa 0,02 - 3 mm, besonders bevorzugt 0,1 - 1 mm. Bevorzugt ist es, wenn zumindest ein Teilbereich der Fläche des Extraktionsgitters einen Ausschnitt aus der Mantelfläche eines zylinderartigen, insbesondere zylinderförmigen Raumkörpers ist. Beispielsweise kann das Extraktionsgitter 4 eine rechteckförmige Grundfläche haben, die einer entsprechend ausgebildeten Austrittsöffnung der Hf-Plasmastrahlquelle 1 entspricht. Bei einem zylinderförmigen Raumkörper kann die Längsachse des Zylinders parallel zu einer der Seiten des Rechtecks angeordnet sein. Durch die Wölbung des Zylindermantels wird jeweils eine konkave bzw. konvexe Form gegenüber dem Plasma verwirklicht.

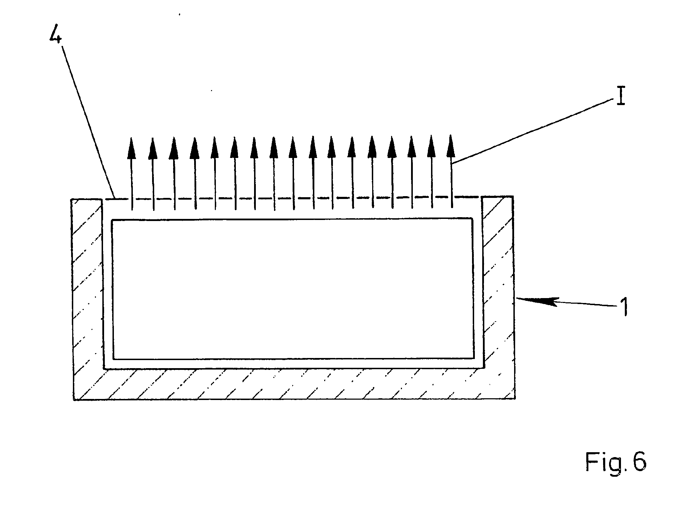

Zum Vergleich zeigt Fig. 6 schematisch eine Hf-Plasmastrahlquelle 1 mit einem planaren Extraktionsgitter 4 im Bereich einer Austrittsöffnung und einem Plasmastrahl I mit hoher Parallelität nach dem Stand der Technik. Die Plasmarandschicht am Extraktionsgitter 4 ist im wesentlichen planar. Nach allgemeiner Lehre, wie beispielsweise aus der EP 349 556 B1 bekannt, ist das Extraktionsgitter 4 so feinmaschig ausgebildet, dass das Plasma nicht davon beeinflusst wird. Die Maschenweite wird daher kleiner als die Dicke der Raumladungszone zwischen Extraktionsgitter 4 und Plasma gewählt.

Die Dicke d der Raumladungszone kann aus Textbüchern entnommen werden. Danach hängt die Dikke d von der Stromdichte j und dem Spannungsabfall U zwischen dem Plasmarand und dem Extraktionsgitter 4 ab:

$$d = \sqrt{\frac{4\varepsilon_0}{9 \cdot j}} \cdot \sqrt[4]{\frac{2 \cdot e}{m_{ion}}} \cdot U^{\frac{3}{4}}$$

mit

$\varepsilon_0$: Dielektrizitätskonstante des Vakuums
e: Elementarladung
$m_{ion}$: Masse der beteiligten Ionen
U: Spannungsabfall zwischen dem Plasmarand und dem Extraktionsgitter 4 (entspricht der Extraktionsspannung)

Zur Bestimmung einer erfindungsgemäßen vergrößerten Maschenweite des Extraktionsgitters 4 wird wie folgt vorgegangen.

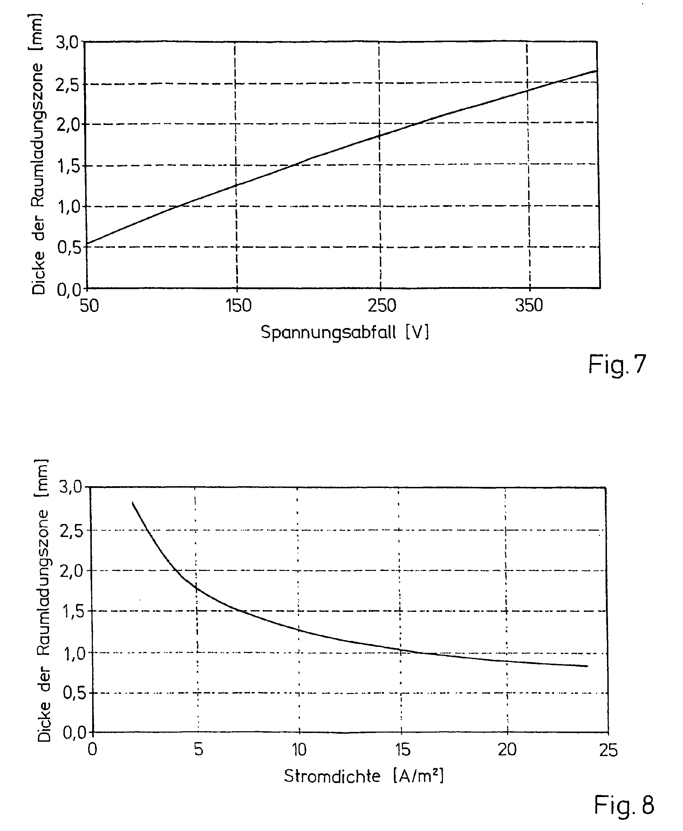

Für einen Ionenstrom von 10 A/m², der einen üblichen Wert für den Betrieb derartiger Beschichtungsanlagen darstellt, wurde bei einer Hf-Plasmastrahlquelle mit einer Austrittsöffnung von 0,1 m² die Dicke d der Raumladungszone berechnet. Dies ist in Fig. 7 dargestellt. Die Dicke d der Raumladungsschicht steigt demnach mit zunehmendem Spannungsabfall an und variiert zwischen 0,5 mm bis zu 2,5 mm bei einem Spannungsabfall zwischen ca. 50 und ca. 370 Volt. Die Dicke d in einem bevorzugten Spannungsbereich zwischen 50 und 200 Volt ist deutlich kleiner als 2 mm.

Betrachtet man die Abhängigkeit der Dicke d der Raumladungszone von der Ionenstromdichte bei fester Extraktionsspannung, z. B. bei 150 Volt, ergibt sich die in Fig. 8 dargestellte Kurve. Die Dicke der Raumladungsschicht d fällt bei fester Extraktionsspannung mit steigender Stromdichte. In einem bevorzugten Bereich zwischen 4 A/m² und 25 A/m² ist die Dicke d der Raumladungszone geringer als 2 mm.

Fig. 9 zeigt schematisch eine erfindungsgemäße Plasmastrahlquelle 1 mit einer bevorzugten Ausgestaltung eines Extraktionsgitters 4 mit Maschen mit vergrößerter Maschenweite. Ist die Maschenweite größer als die Dicke d der Raumladungszone, so verformt sich die Plasmarandschicht in diesem Bereich, wie durch die wellige Kurve unterhalb des Extraktionsgitters 4 angedeutet ist. Dies führt zu einer erhöhten Divergenz des Plasmastrahls I. Sinnvollerweise sollte die Maschenweite noch klein genug sein, damit das Plasma nicht merklich durch die Austrittsöffnung entweicht. Zweckmäßigerweise beträgt die Maschenweite bevorzugt höchstens 30 mm, besonders vorzugsweise höchstens 20mm, insbesondere, wenn die Dicke der Raumladungzone in einem Bereich zwischen 0,5 und 2,5 mm liegt.

Fig. 10 zeigt schematisch eine weitere bevorzugte Ausgestaltung eines Extraktionsgitters 4, welches nicht planar, sondern konkav vom Plasmaraum 3 ausgesehen, ausgebildet ist. Dadurch bildet sich eine gekrümmte Plasmarandschicht aus, und der austretende Plasmastrahl I zeigt eine divergente Strahlungscharakteristik. Hier kann die Maschenweite des Extraktionsgitters 4 auch relativ klein, insbesondere geringer als die Dicke der Raumladungszone gewählt werden. Das Extraktionsgitter 4 kann auch konvex ausgebildet sein.

Bei einer weiteren Ausführungsform kann das Extraktionsgitter 4 über zumindest einen Teilbereich seiner Fläche inhomogen ausgebildet sein. Hierzu kann beispielsweise eine Maschenweite variiert werden, so dass zum Rand hin eine geringere Maschenweite vorgesehen ist. Ferner können zur Modulation des Plasmastrahls außerhalb des Plasmaraums 3 eine oder mehrere Blenden vorgesehen sein. Ebenso kann die Austrittsöffnung in Teilbereichen mit Blenden abgedeckt sein und damit sonst inhomogen bestrahlte Bereiche der Oberfläche ausgeblendet werden. Die Blenden können zusätzlich mit einem elektrischen Potential beaufschlagt sein, um den Plasmastrahl zusätzlich zu modulieren.

Ferner kann eine aus der EP 349 556 B1 an sich bekannte Hf-Plasmastrahlquelle mit einem planaren Extraktionsgitter zur Bestrahlung von auf einer Kalotte angeordneten Substraten verwendet werden, wobei jedoch in einem Raumbereich außerhalb des Plasmaraums der Quelle zumindest eine Blende angeordnet ist. Diese Blende moduliert den Plasmastrahl derart, dass die ansonsten inhomogen bestrahlten Bereiche auf der Kalotte von der Bestrahlung ausgenommen werden. Dies kann ebenso durch die Abdeckung von Teilbereichen der Austrittsöffnung erfolgen. Die Form der verwendeten Blenden wird vorzugsweise empirisch anhand der erreichten Bestrahlungsergebnisse bestimmt. Zusätzlich ist vorgesehen, dass die Blenden mit einem elektrischen Potential zur Modulation des Plasmastrahls beaufschlagt sind.

**BEZUGSZEICHENLISTE**

1 Hochfrequenz-Plasmastrahlquelle
2 Gehäuse
3 Plasmaraum
4 Extraktionsgitter
5 Magnet
6 Gas-Zuführung
7 Beschichtungskammer
8 Hochfrequenz-Sender
9 Elektrische Verbindung
10 Substrate
11 Kalotte
I Plasmastrahl
$K_s$ Kalottensymmetrieachse
$\alpha$ Kalottenwinkel
$R_Q$ Radialer Abstand Quelle - Symmetrieachse
$Y_Q$ Vertikaler Abstand Quelle - Symmetriezentrum

**Patentansprüche**

1. Hochfrequenz-Plasmastrahlquelle mit einem Plasmaraum (3) für ein Plasma, elektrischen Mitteln (8, 9) zum Zünden und Erhalt des Plasmas, einem Extraktionsgitter (4) zum Extrahieren eines neutralen Plasmastrahls (I) aus dem Plasmaraum (3) sowie einer Austrittsöffnung, vorzugsweise zu einer Vakuumkammer (7), wobei das Extraktionsgitter (4) im Bereich der Austrittsöffnung angeordnet ist, **dadurch gekennzeichnet, dass** zur Erreichung eines divergent ausgebildeten Plasmastrahls (I) das Extraktionsgitter (4) vom Plasmaraum (3) aus gesehen konkav oder konvex ausgebildet ist.

2. Hochfrequenz-Plasmastrahlquelle nach Anspruch 1, **dadurch gekennzeichnet, dass** der Plasmastrahl ein Divergenzmaß von höchstens n = 16, bevorzugt n=4, wobei n ein Exponent einer Cosinus-Verteilungsfunktion $\cos^n$ ist, aufweist.

3. Hochfrequenz-Plasmastrahlquelle nach einem der vorhergehenden Ansprüche, **dadurch gekennzeichnet, dass** in einer Beschichtungskammer (7) der Austrittsöffnung im wesentlichen gegenüberliegend, eine zu bestrahlende gekrümmte, insbesondere kugelförmige Oberfläche vorgesehen ist und zur Erreichung einer hohen Homogenität der Plasmastromdichte auf zumindest einem Teilbereich der zu bestrahlenden Oberfläche, der Plasmastrahl (I) der Form von zumindest einem Teilbereich der Oberfläche anpassbar ist.

4. Hochfrequenz-Plasmastrahlquelle nach einem der vorhergehenden Ansprüche, **dadurch gekennzeichnet, dass** das zumindest ein Teilbereich der Fläche des Extraktionsgitter ein Ausschnitt aus der Mantelfläche eines zylinderartigen Raumkörpers ist.

5. Hochfrequenz-Plasmastrahlquelle nach einem der vorhergehenden Ansprüche, **dadurch gekennzeichnet, dass** das Extraktionsgitter (4) über zumindest einen Teilbereich seiner Fläche inhomogen ausgebildet ist.

6. Hochfrequenz-Plasmastrahlquelle nach einem der vorhergehenden Ansprüche, **dadurch gekennzeichnet, dass** zumindest eine außerhalb des Plasmaraums (3) angeordnete Blende vorgesehen ist.

7. Hochfrequenz-Plasmastrahlquelle nach einem der vorhergehenden Ansprüche, **dadurch gekennzeichnet, dass** die Austrittsöffnung in Teilbereichen mit Blenden abgedeckt ist.

8. Hochfrequenz-Plasmastrahlquelle nach einem der vorhergehenden Ansprüche, **dadurch gekennzeichnet, dass** zur Modulierung des Plasmastrahls (I) zumindest eine Blende mit einem elektrischen Potential beaufschlagbar ist.

9. Hochfrequenz-Plasmastrahlquelle nach Anspruch 3, **dadurch gekennzeichnet, dass** die Oberfläche eine Kalotte (11), vorzugsweise mit Substraten (10.1, 10.2, 10.3, 10.4, 10.5, 10.6) ist.

10. Hochfrequenz-Plasmastrahlquelle nach einem der vorhergehenden Ansprüche, **dadurch gekennzeichnet, dass** zusätzlich zur Hochfrequenz-Plasmastrahlquelle (1) eine Verdampfungsquelle vorgesehen ist.

11. Hochfrequenz-Plasmastrahlquelle nach einem der vorhergehenden Ansprüche, **dadurch gekennzeichnet, dass** das Extraktionsgitter (4) aus einem Wolframnetz mit einer Drahtstärke von etwa 0,02 - 3 mm, bevorzugt 0,1 - 1 mm, gebildet ist.

12. Hochfrequenz-Plasmastrahlquelle nach einem der vorhergehenden Ansprüche, **dadurch gekennzeichnet, dass** zumindest ein Magnet (5) zur Einschließung des Plasmas im Bereich des Plasmaraums (3) vorgesehen ist.

**13.** Vakuumkammer mit einem Gehäuse (2), einer Hochfrequenz-Plasmastrahlquelle und einer zu bestrahlenden Oberfläche, **dadurch gekennzeichnet, dass** die Hochfrequenz-Plasmastrahlquelle (1) nach zumindest einem der vorhergehenden Ansprüche ausgebildet ist.

**14.** Verwendung einer Hochfrequenz-Plasmastrahlquelle mit einem Plasmaraum (3) für ein Plasma, elektrischen Mitteln (8, 9) zum Zünden und Erhalt des Plasmas, einem Extraktionsgitter (4) zum Extrahieren eines neutralen Plasmastrahls (I) aus dem Plasmaraum (3) sowie einer Austrittsöffnung, vorzugsweise zu einer Vakuumkammer (7), wobei das Extraktionsgitter (4) im Bereich der Austrittsöffnung angeordnet ist, **dadurch gekennzeichnet, dass** zur Erreichung eines divergent ausgebildeten Plasmastrahls (I) das Extraktionsgitter (4) vom Plasmaraum (3) aus gesehen konkav oder konvex ausgebildet ist und/oder das Extraktionsgitter (4) eine Maschenweite aufweist, die größer als die Dicke(d) einer Raumladungszone zwischen Extraktionsgitter (4) und dem Plasma im Plasmaraum (3) ist.

**15.** Verfahren zum Bestrahlen einer Oberfläche mit einem Plasmastrahl einer Hochfrequenz-Plasmastrahlquelle mit einem Plasmaraum (3) für ein Plasma, elektrischen Mitteln (8, 9) zum Zünden und Erhalt des Plasmas, einem Extraktionsgitter (4) zum Extrahieren eines neutralen Plasmastrahls (I) aus dem Plasmaraum (3) sowie einer Austrittsöffnung, vorzugsweise zu einer Vakuumkammer (7), wobei das Extraktionsgitter (4) im Bereich der Austrittsöffnung angeordnet ist, **dadurch gekennzeichnet, dass** zur Erreichung eines divergent ausgebildeten Plasmastrahls (I) zum Extrahieren des Plasmastrahls (I) ein vom Plasmaraum (3) aus gesehen konkav oder konvex ausgebildetes Extraktionsgitter (4) und/oder ein Extraktionsgitter (4) mit einer Maschenweite größer als eine Dicke (d) Raumladungszone zwischen Extraktionsgitter (4) und Plasma verwendet wird.

**16.** Verfahren nach Anspruch 15, **dadurch gekennzeichnet, dass** ein Plasmastrahl (I) mit einem Divergenzmaß von höchstens n = 16, bevorzugt n=4, wobei n ein Exponent einer Cosinus-Verteilungsfunktion $\cos^n$ ist, verwendet wird.

**17.** Verfahren nach einem der Ansprüche 15 bis 16, **dadurch gekennzeichnet, dass** in einer Beschichtungskammer (7) der Austrittsöffnung im wesentlichen gegenüberliegend, eine zu bestrahlende gekrümmte, insbesondere kugelförmige Oberfläche angeordnet wird und zur Erreichung einer hohen Homogenität der Plasmastromdichte auf zumindest einem Teilbereich der zu bestrahlenden Oberfläche, der Plasmastrahl (I) der Form von zumindest einem Teilbereich der Oberfläche angepasst wird.

**18.** Verfahren nach Anspruch 17, **dadurch gekennzeichnet, dass** ein Extraktionsgitter (4) gewählt wird, welches vom Plasmaraum (3) aus gesehen konkav oder konvex ausgebildet ist, wobei vorzugsweise zumindest ein Teilbereich der Fläche des Extraktionsgitter ein Ausschnitt aus der Mantelfläche eines zylinderartigen Raumkörpers ist.

**19.** Verfahren nach einem der Ansprüche 17 bis 18, **dadurch gekennzeichnet, dass** durch das Bestrahlen der Oberfläche eine Beschichtung der Oberfläche erfolgt.

**20.** Verfahren nach einem der Ansprüche 17 bis 19, **dadurch gekennzeichnet, dass** durch das Bestrahlen der Oberfläche eine Modifizierung und/oder Reinigung der Oberfläche erfolgt.

**Claims**

**1.** High-frequency plasma jet source comprising a plasma space (3) for a plasma, electrical means (8, 9) for igniting and sustaining the plasma, an extraction grid (4) for extracting a neutral plasma jet (I) from the plasma space (3) and an exit opening, preferably to a vacuum chamber (7), the extraction grid (4) being arranged in the region of the exit opening, **characterized in that** the extraction grid (4) is formed as concave or convex, as seen from the plasma space (3), to achieve a divergently formed plasma jet (I).

**2.** High-frequency plasma jet source according to Claim 1, **characterized in that** the plasma jet has a degree of divergence of at most n = 16, preferably n = 4, where n is an exponent of a cosine distribution function $\cos^m$.

**3.** High-frequency plasma jet source according to one of the preceding claims, **characterized in that** a curved, in particular spherical, surface to be irradiated is provided in a coating chamber (7), lying substantially opposite the exit opening, and the plasma jet (I) is adaptable to the shape of at least a partial region of the surface to achieve a high level of homogeneity of the density of the plasma jet on at least a partial region of the surface to be irradiated.

**4.** High-frequency plasma jet source according to one of the preceding claims, **characterized in that** at least a partial region of the surface of the extraction grid is a cutout from the lateral surface of a cylindrical three-dimensional body.

**5.** High-frequency plasma jet source according to one of the preceding claims, **characterized in that** the extraction grid (4) is formed inhomogeneously over at least one partial region of its surface.

6. High-frequency plasma jet source according to one of the preceding claims, **characterized in that** at least one mask is provided, arranged outside the plasma space (3).

7. High-frequency plasma jet source according to one of the preceding claims, **characterized in that** partial regions of the exit opening are covered by masks.

8. High-frequency plasma jet source according to one of the preceding claims, **characterized in that** at least one mask can be subjected to an electric potential to modulate the plasma jet (I).

9. High-frequency plasma jet source according to Claim 3, **characterized in that** the surface is a dome (11), preferably with substrates (10.1, 10.2, 10.3, 10.4, 10.5, 10.6).

10. High-frequency plasma jet source according to one of the preceding claims, **characterized in that** an evaporation source is provided in addition to the high-frequency plasma jet source (1).

11. High-frequency plasma jet source according to one of the preceding claims, **characterized in that** the extraction grid (4) is formed by a tungsten mesh with a wire thickness of approximately 0.02 - 3 mm, preferably 0.1 - 1 mm.

12. High-frequency plasma jet source according to one of the preceding claims, **characterized in that** at least one magnet (5) is provided to confine the plasma within the region of the plasma space (3).

13. Vacuum chamber comprising a housing (2), a high-frequency plasma jet source and a surface to be irradiated, **characterized in that** the high-frequency plasma jet source (1) is formed according to at least one of the preceding claims.

14. Use of a high-frequency plasma jet source comprising a plasma space (3) for a plasma, electrical means (8, 9) for igniting and sustaining the plasma, an extraction grid (4) for extracting a neutral plasma jet (I) from the plasma space (3) and an exit opening, preferably to a vacuum chamber (7), the extraction grid (4) being arranged in the region of the exit opening, **characterized in that** the extraction grid (4) is formed as concave or convex, as seen from the plasma space (3), to achieve a divergently formed plasma jet (I) and/or the extraction grid (4) has a mesh width which is greater than the thickness (d) of a space charge zone between the extraction grid (4) and the plasma in the plasma space (3).

15. Method for irradiating a surface with a plasma jet of a high-frequency plasma jet source comprising a plasma space (3) for a plasma, electrical means (8, 9) for igniting and sustaining the plasma, an extraction grid (4) for extracting a neutral plasma jet (I) from the plasma space (3) and an exit opening, preferably to a vacuum chamber (7), the extraction grid (4) being arranged in the region of the exit opening, **characterized in that** an extraction grid (4) formed as concave or convex, as seen from the plasma space (3), and/or an extraction grid (4) with a mesh width greater than a thickness (d) of the space charge zone between the extraction grid (4) and the plasma is used for extracting the plasma jet (I) to achieve a divergently formed plasma jet (I).

16. Method according to Claim 15, **characterized in that** a plasma jet (I) with a degree of divergence of at most n = 16, preferably n = 4, where n is an exponent of a cosine distribution function $\cos^m$, is used.

17. Method according to either of Claims 15 and 16, **characterized in that** a curved, in particular spherical, surface to be irradiated is arranged in a coating chamber (7), lying substantially opposite the exit opening, and the plasma jet (I) is adapted to the shape of at least a partial region of the surface to achieve a high level of homogeneity of the density of the plasma jet on at least a partial region of the surface to be irradiated.

18. Method according to Claim 17, **characterized in that** an extraction grid (4) which is formed as concave or convex, as seen from the plasma space (3), is chosen, preferably at least a partial region of the surface of the extraction grid being a cutout from the lateral surface of a cylindrical three-dimensional body.

19. Method according to either of Claims 17 and 18, **characterized in that** the irradiation of the surface has the effect of coating the surface.

20. Method according to one of Claims 17 to 19, **characterized in that** the irradiation of the surface has the effect of modifying and/or cleaning the surface.

**Revendications**

1. Source de faisceau plasma à haute fréquence dotée d'un espace (3) pour un plasma, de moyens électriques (8, 9) qui allument et maintiennent le plasma, d'une grille d'extraction (4) qui extrait un faisceau neutre (I) de plasma hors de l'espace (3) à plasma ainsi que d'une ouverture de sortie, de préférence vers une chambre (7) sous vide, la grille d'extraction (4) étant disposée dans la zone occupée par l'ouverture de sortie,
**caractérisée en ce que**
pour obtenir un faisceau (I) de plasma de configuration divergente, la grille d'extraction (4) vue de l'espace (3) à plasma a une configuration concave ou convexe.

2. Source de faisceau plasma à haute fréquence selon la revendication 1, **caractérisée en ce que** le faisceau de plasma présente une dimension de divergence d'au plus n = 16, de préférence de n = 4, n étant l'exposant d'une fonction $\cos^n$ de répartition de cosinus.

3. Source de faisceau plasma à haute fréquence selon l'une des revendications précédentes, **caractérisée en ce qu'**une surface cintrée à irradier, en particulier une surface sphérique, est prévue dans une chambre (7) de revêtement située essentiellement face à l'ouverture de sortie et **en ce que** pour obtenir une homogénéité élevée de la densité de courant du plasma sur au moins une partie de la surface à irradier, la forme du faisceau (I) de plasma peut être adaptée à celle d'au moins une partie de la surface.

4. Source de faisceau plasma à haute fréquence selon l'une des revendications précédentes, **caractérisée en ce que** la ou les parties de la surface de la grille d'extraction font partie de la surface d'enveloppe d'un corps tridimensionnel de type cylindre.

5. Source de faisceau plasma à haute fréquence selon l'une des revendications précédentes, **caractérisée en ce qu'**au moins une partie de la surface de la grille d'extraction (4) a une configuration non homogène.

6. Source de faisceau plasma à haute fréquence selon l'une des revendications précédentes, **caractérisée en ce qu'**au moins un écran est prévu à l'extérieur de l'espace (3) à plasma.

7. Source de faisceau plasma à haute fréquence selon l'une des revendications précédentes, **caractérisée en ce que** des parties de l'ouverture de sortie sont recouvertes par des écrans.

8. Source de faisceau plasma à haute fréquence selon l'une des revendications précédentes, **caractérisée en ce que** pour moduler le faisceau (I) de plasma, un potentiel électrique peut être appliqué sur au moins un écran.

9. Source de faisceau plasma à haute fréquence selon la revendication 3, **caractérisée en ce que** la surface est une calotte (11) de préférence dotée de substrats (10.1, 10.2, 10.3, 10.4, 10.5, 10.6).

10. Source de faisceau plasma à haute fréquence selon l'une des revendications précédentes, **caractérisée en ce qu'**une source de vaporisation est prévue en plus de la source (1) de faisceau de plasma à haute fréquence.

11. Source de faisceau plasma à haute fréquence selon l'une des revendications précédentes, **caractérisée en ce que** la grille d'extraction (4) est formée par un treillis de tungstène dont la densité de fils est d'environ 0,02 à 3 mm et de préférence de 0,01 à 1 mm.

12. Source de faisceau plasma à haute fréquence selon l'une des revendications précédentes, **caractérisée en ce qu'**au moins un aimant (5) est prévu pour confiner le plasma dans la zone occupée par l'espace (3) à plasma.

13. Chambre sous vide dotée d'un boîtier (2), d'une source de faisceau de plasma à haute fréquence et d'une surface à irradier, **caractérisée en ce que** la source (1) de plasma à haute fréquence est configurée selon au moins l'une des revendications précédentes.

14. Utilisation d'une source de faisceau de plasma à haute fréquence dotée d'un espace (3) pour un plasma, de moyens électriques (8, 9) qui allument et maintiennent le plasma, d'une grille d'extraction (4) qui extrait un faisceau neutre (I) de plasma hors de l'espace (3) à plasma ainsi que d'une ouverture de sortie, de préférence vers une chambre (7) sous vide, la grille d'extraction (4) étant disposée dans la zone occupée par l'ouverture de sortie,
**caractérisée en ce que**
pour obtenir un faisceau (I) de plasma de configuration divergente, la grille d'extraction (4) vue de l'espace (3) à plasma a une configuration concave ou convexe et/ou
**en ce que** la grille d'extraction (4) présente une maille d'une taille supérieure à l'épaisseur (d) d'une zone de charge spatiale entre la grille d'extraction (4) et le plasma présent dans l'espace (3) à plasma.

15. Procédé d'irradiation d'une surface à l'aide d'un faisceau de plasma provenant d'une source de faisceau de plasma à haute fréquence qui présente un espace (3) pour un plasma, des moyens électriques (8, 9) qui allument et maintiennent le plasma, une grille d'extraction (4) qui extrait un faisceau neutre (I) de plasma hors de l'espace (3) à plasma ainsi qu'une ouverture de sortie, de préférence vers une chambre (7) sous vide, la grille d'extraction (4) étant disposée dans la zone occupée par l'ouverture de sortie, **caractérisé en ce que**
pour obtenir un faisceau (I) de plasma de configuration divergente, la grille d'extraction (4) vue de l'espace (3) à plasma a une configuration concave ou convexe et/ou

**en ce que** la grille d'extraction (4) présente une maille d'une taille supérieure à l'épaisseur (d) d'une zone de charge spatiale entre la grille d'extraction (4) et le plasma présent dans l'espace (3) à plasma.

**16.** Procédé selon la revendication 15, **caractérisé en ce qu'**il utilise un faisceau (I) de plasma qui présente une dimension de divergence d'au plus n = 16, de préférence de n = 4, n étant l'exposant d'une fonction $\cos^n$ de répartition de cosinus.

**17.** Procédé selon l'une des revendications 15 à 16, **caractérisé en ce qu'**une surface cintrée à irradier, en particulier une surface sphérique, est prévue dans une chambre (7) de revêtement située essentiellement face à l'ouverture de sortie et **en ce que** pour obtenir une homogénéité élevée de la densité de courant du plasma sur au moins une partie de la surface à irradier, la forme du faisceau (I) de plasma peut être adaptée à celle d'au moins une partie de la surface.

**18.** Procédé selon la revendication 17, **caractérisé en ce que** l'on y sélectionne une grille d'extraction (4) dont la configuration vue de l'espace (3) à plasma est concave ou convexe, et dans lequel de préférence au moins une partie de la surface de la grille d'extraction est une partie de la surface d'enveloppe d'un corps tridimensionnel de type cylindre.

**19.** Procédé selon l'une des revendications 17 à 18, **caractérisé en ce que** l'irradiation de la surface entraîne un revêtement de la surface.

**20.** Procédé selon l'une des revendications 17 à 19, **caractérisé en ce que** l'irradiation de la surface entraîne une modification et/ou un nettoyage de la surface.

Fig.1

Fig.3

Fig. 2

Fig. 4

—■— groß, n = 16
—●— klein, n = 16
—◆— n = 8
——— n = 4

Fig. 5

Fig. 6

Fig. 7

Fig. 8

Fig. 9

Fig. 10

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 349556 B1

- US 6250070 B1

### In der Beschreibung aufgeführte Nicht-Patentliteratur

- **G. Deppisch.** Schichtdickengleichmäßigkeit von aufgedampften Schichten in Theorie und Praxis. *Vakuum Technik,* 1981, vol. 30 (3